# Europäisches Patentamt
## European Patent Office
## Office européen des brevets

(11) Veröffentlichungsnummer **0 051 179**
B1

(12)

# EUROPÄISCHE PATENTSCHRIFT

(45) Veröffentlichungstag der Patentschrift:
19.09.84

(51) Int. Cl.³: **H 03 D 7/14**, H 04 B 1/28

(21) Anmeldenummer: 81108332.8

(22) Anmeldetag: 14.10.81

(54) Integrierbare-Oszillatorschaltung.

(30) Priorität: 03.11.80 DE 3041392
05.12.80 DE 3045993

(43) Veröffentlichungstag der Anmeldung:
12.05.82 Patentblatt 82/19

(45) Bekanntmachung des Hinweises auf die Patenterteilung:
19.09.84 Patentblatt 84/38

(84) Benannte Vertragsstaaten:
DE FR GB IT

(56) Entgegenhaltungen:
DE - A - 2 038 435
DE - A - 2 850 778
US - A - 4 058 771
US - A - 4 227 095

IEEE INTERNATIONAL SOLID STATE CIRCUITS CONF.,
Band XXII, Februar 1979 S. KOMATSU et al. "Session
XVII: "Linear Circuit Techniques" Seiten 236, 237 und
296
FUNKSCHAU, Nr. 15, 1971 G. PELTZ "Zweipolige
Oszillatorschaltungen für Parallel- und Serienresonanz"
Seiten 465 bis 466

(73) Patentinhaber: Siemens Aktiengesellschaft, Berlin und
München Wittelsbacherplatz 2, D-8000 München 2 (DE)

(72) Erfinder: Fenk, Josef, Dipl.-Ing.,
Deutenhauserstrasse 10, D-8057 Eching/Ottenburg (DE)

## Beschreibung

Die Erfindung betrifft eine integrierbare Oszillatorschaltung mit einer durch ein externes Signal beaufschlagten Mischstufe, bei der der Oszillator von einem aus zwei emittergekoppelten Transistoren bestehenden Differenzverstärker gebildet ist, dessen beide Transistoren an ihren Emittern durch das von einer Gleichspannungsquelle gelieferte Bezugspotential und an ihren Kollektoren unter Vermittlung je eines Widerstands durch das von dieser Gleichspannungsquelle gelieferte Betriebspotential beaufschlagt sind, bei der der Basisanschluß des ersten Transistors des Differenzverstärkers durch einen Schwingkreis oder einen Schwingquarz gesteuert und der Basisanschluß des zweiten Transistors des Differenzverstärkers über einen Kondensator an das Bezugspotential angeschlossen ist, bei der außerdem der Kollektor des zweiten Transistors einen die im Oszillator erzeugte elektrische Schwingung abgebenden Signalausgangsanschluß bildet und bei der schließlich eine rückkoppelnde Verbindung zwischen dem Kollektor des zweiten Transistors zur Basis des ersten Transistors vorgesehen ist.

Schwingkreis- bzw. quarzgesteuerte Oszillatorschaltungen, bei denen der Kern des Oszillators durch einen rückgekoppelten und durch zwei emittergekoppelte Transistoren gegebenen Differenzverstärker realisiert ist, sind z. B. aus »Funkschau« (1971), H. 15, S. 465 und 466 bekannt. Sie sind sowohl für den Betrieb mit parallel- als auch mit seriell aufgebauten Schwingkreisen geeignet und arbeiten trotz ihres einfachen Aufbaus selbst bei stark unterschiedlichen Resonanzwiderständen einwandfrei, ohne daß es zur Entstehung von Kippschwingungen kommt. Außerdem ist die Amplitude am Schwingkreis stabilisiert und die Schaltung weitgehend monolithisch zusammenfaßbar. Verwendet man jedoch den Oszillator zur Beaufschlagung einer Mischstufe, insbesondere in einer integrierten Oszillator-Tuner-Mischerschaltung, so wird bei Anwendung der üblichen Schaltungsweisen bei weitem nicht das Optimum hinsichtlich der Unterdrückung der Wirkung des Eingangssignals bzw. des Oszillatorsignals auf den Ausgang der Mischstufe und damit auf die Wiedergabequalität des eine solche Schaltung verwendenden Rundfunk- oder Fernsehempfängers erreicht. Auch hinsichtlich der Unterdrückung des Oszillatorrauschens sind die bekannten Schaltungen dieser Art verbesserungsbedürftig.

Es ist Aufgabe der vorliegenden Erfindung hier eine Lösung anzugeben, die die genannten Nachteile der bekannten Oszillatorschaltungen nicht aufweist.

Eine der eingangs gegebenen Definition entsprechende Oszillatorschaltung ist ferner in der DE-AS 2 038 435 beschrieben, die jedoch nicht für die Beaufschlagung einer Mischstufe vorgesehen ist. Vielmehr handelt es sich bei dieser bekannten Oszillatorschaltung darum, sie derart auszugestalten, daß sie sowohl für die Erzeugung von Sinuswellen als auch für die Erzeugung von Rechteckwellen geeignet ist. Hierzu ist bei der bekannten Oszillatorschaltung in der rückkoppelnden Verbindung entweder ein aus der Serienschaltung eines Kondensators mit einer Induktivität bestehender Schwingkreis oder die Serienschaltung eines Kondensators mit einem Widerstand vorgesehen. Durch eine solche Art der Rückkopplung läßt sich jedoch die von der Erfindung behandelte Aufgabe nicht lösen.

Vielmehr ist hierzu gemäß der Erfindung die integrierbare Oszillatorschaltung der eingangs definierten Art derart ausgestaltet, daß die Kollektoren der beiden den Differenzverstärker bildenden Transistoren sowohl an je einen Eingangsanschluß der symmetrisch ausgebildeten Mischstufe als auch über je einen Tiefpaß an je einen Eingang eines Regelverstärkers gelegt sind und der Ausgang dieses Regelverstärkers auf den Oszillator im Sinne einer gleichstrommäßigen Gegenkopplung rückgekoppelt ist, derart, daß die Kollektorpotentiale der beiden Transistoren des Oszillators und damit auch die Potentiale an den beiden Eingängen der Mischstufe möglicht symmetrisch liegen.

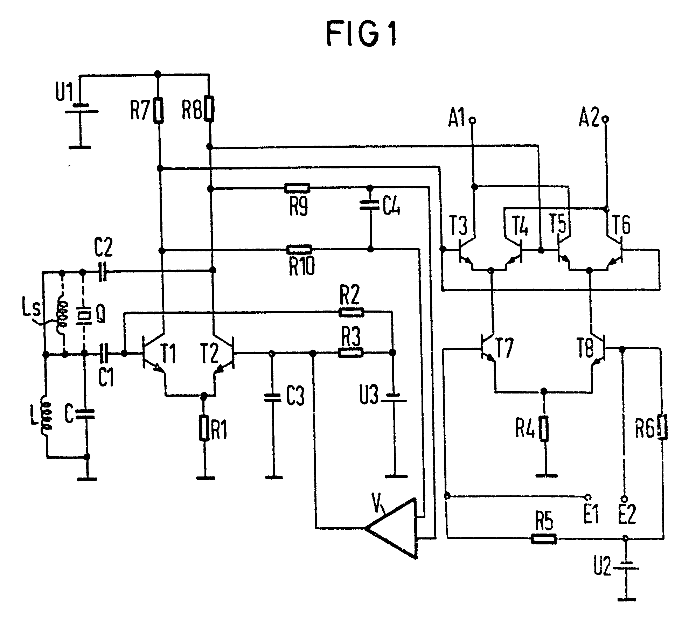

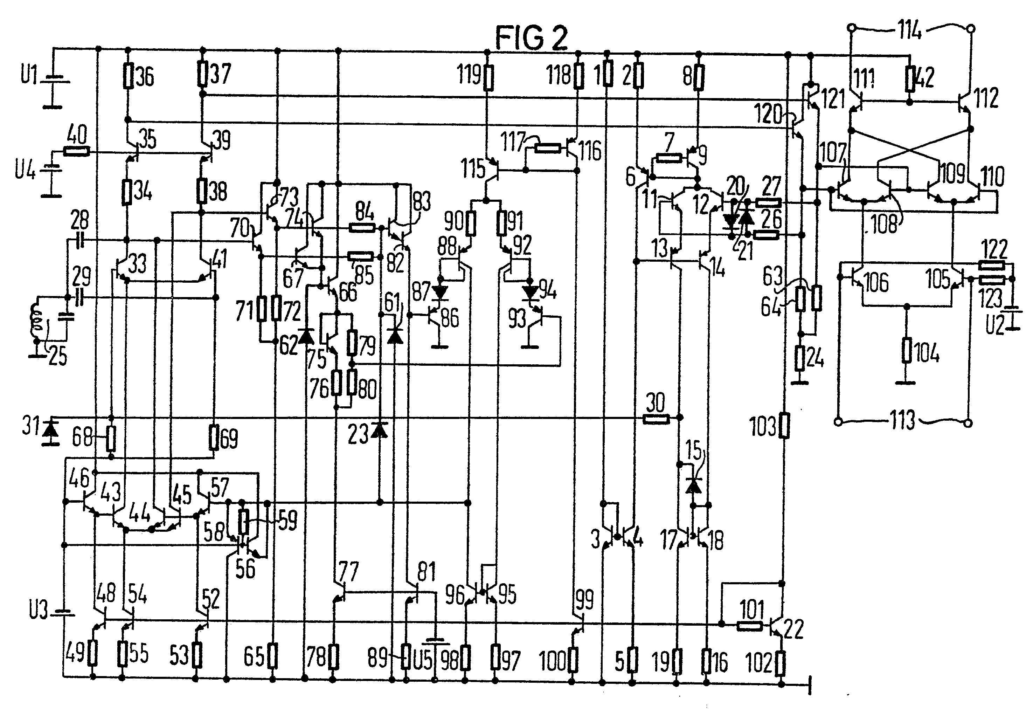

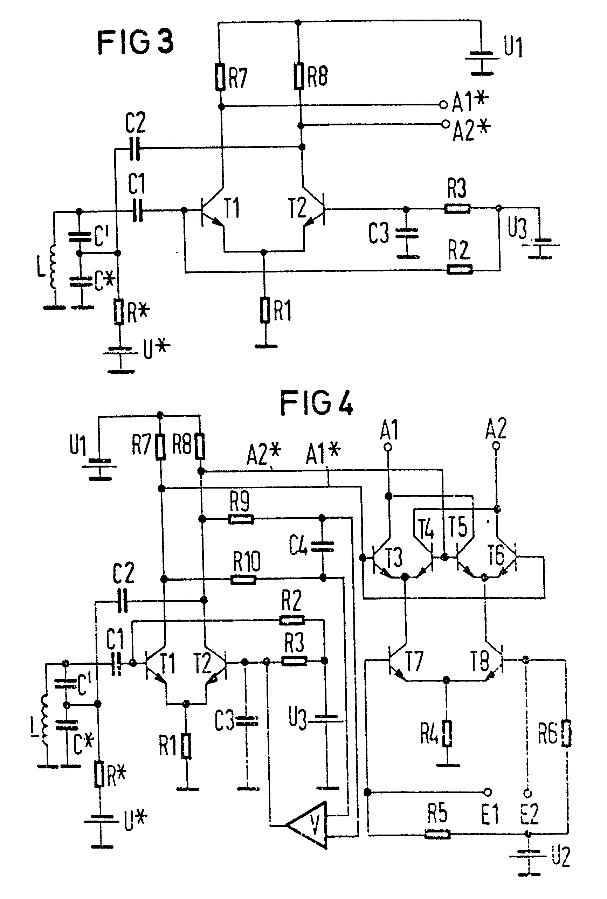

Die Erfindung wird nun anhand der Fig. 1 und 2 sowie eine weitere Ausgestaltung anhand der Fig. 3 und 4 näher beschrieben. Dabei wird zunächst auf Fig. 1 Bezug genommen, in der das allgemeine Prinzip der erfindungsgemäßen Oszillatorschaltung dargestellt ist. Die aus Fig. 2 ersichtliche Ausgestaltung stellt eine besonders vorteilhafte Weiterentwicklung dieser Schaltung dar. Falls noch zusätzlich eine Verminderung der Frequenzdrift sowie eine Vergrößerung des Durchstimmbereiches sowie eine Erhöhung der Schwingsicherheit angestrebt ist, so läßt sich die erfindungsgemäße Schaltung in der aus Fig. 3 bzw. Fig. 4 gezeigten Weise weiter verbessern. Die in den Figuren gezeigten Ausgestaltungen sind mittels Bipolartransistoren aufgebaut. Es lassen sich jedoch auch sowohl der Oszillator als auch die Mischstufe als auch die für die Gegenkopplung auf den Oszillator einzusetzenden Schaltungsteile in MOS-Technik realisieren.

Die beiden den Oszillator bei der Schaltung gemäß Fig. 1 bildenden Bipolartransistoren $T1$ und $T2$ sind einander gleich und vom npn-Typ. Sie sind mit ihren Emittern verbunden und über einen Widerstand $R1$ an das als Bezugspotential (Masse) dienende zweite Betriebspotential gelegt, das von einer Gleichspannungsquelle $U1$ zur Verfügung gestellt ist. Der das erste Betriebspotential liefernde andere Pol der Gleichspannungsquelle $U1$ liegt über je einen Widerstand $R7$ bzw. $R8$ am Kollektor des ersten Transistors $T1$ und des zweiten Transistors $T2$ des Oszillators.

Die Basis des Transistors $T1$ bildet den Steuereingang des Oszillators, da er über einen Kondensator $C1$ an das frequenzbestimmende Steuerorgan des Oszillators angeschlossen ist. Dieses Steuerorgan ist entweder ein Parallel-Resonanzkreis, also ein aus einem Kondensator C mit parallelgeschalteter Induktivität L gebildeter Schwingkreis, der einerseits am Bezugspotential und andererseits über den Kondensator C1 am Steuereingang T1 des Oszillators liegt sowie über einen weiteren (gleichen) Kondensator C2 mit dem Kollektor des anderen Transistors T2 des Oszillators verbunden ist.

In Alternative hierzu kann der Schwingkreis seriell sein. Dann entfällt die Induktivität L an dieser Stelle und der Schwingkreiskondensator C wird durch eine die beiden dem Oszillator abgewandten Pole der beiden Koppelkondensatoren C1 und C2 ausschließlich verbindende Induktivität Ls ersetzt. Bei einer Quarzsteuerung ersetzt der Schwingquarz Q die serielle Induktivität Ls. Die Parallelinduktivität L und der Parallelkondensator C entfallen in diesem Falle ebenfalls.

Aufgrund dieser die Oszillatorwirkung des Differenzverstärkers T1, T2 bewirkenden Rückkopplung zwischen dem Basisanschluß des Transistors T1 und dem Kollektoranschluß des Transistors T2 sind die Kollektoren der beiden Transistoren T1 und T2 imstande, die nachfolgende Mischstufe mit den zum Betrieb der Schaltung erforderlichen Sinusschwingungen zu versorgen.

Die Basis des Transistors T1 ist mit der Basis des Transistors T2 über zwei hintereinandergeschaltete Widerstände R2 und R3 verbunden. Der Teilerpunkt zwischen diesen beiden Widerständen R2, R3 ist über die Gleichspannungsquelle U3 mit Masse verbunden. Ein weiterer Kondensator C3 ist zwischen dem Basisanschluß des zweiten Transistors T2 und dem Bezugspotential vorgesehen.

Die Mischstufe besteht aus zwei Transistorpaaren T3, T4 und T5, T6, die ebenso wie die Transistoren des Oszillators T1, T2 aus Transistoren vom npn-Typ bestehen. Die symmetrische Mischstufe kommt dadurch zustande, daß die Transistoren T3 und T4 einerseits und die Transistoren T5 und T6 andererseits über ihre Emitter paarweise miteinander verbunden und der Kollektor je eines Transistors der beiden Paare an die eine Ausgangsklemme A1 und der Kollektor je eines der beiden anderen Transistoren der beiden Paare an die andere Ausgangsklemme A2 gelegt ist. Im gezeichneten Beispielsfall liegt der Kollektor des Transistors T3 und der Kollektor des Transistors T5 an der Klemme A1, der Kollektor des Transistors T4 und der Kollektor des Transistors T6 an der Klemme A2 des Ausgangs der Mischstufe.

Andererseits sind die Transistoren T3 und T4 einerseits und die Transistoren T5 und T6 andererseits über ihre Emitter zu jeweils einem Paar zusammengefaßt und jedes der beiden Paare T3, T4 und T5, T6 über seine Emitter mit dem Kollektor je eines weiteren npn-Transistors T7 bzw. T8 verbunden. Diese Transistoren T7 und T8 sind ihrerseits wiederum über ihre Emitter zusammengefaßt und über ihre Emitter über einen gemeinsamen Widerstand R4 am gemeinsamen Bezugspotential der Schaltung angeschaltet. Die Transistoren T3 und T6 bilden über ihre Basisanschlüsse eine erste gemeinsame Eingangsklemme und die Transistoren T4 und T5 eine zweite gemeinsame Eingangsklemme für das vom Oszillatorausgang gelieferte Oszillatorsignal. Deshalb liegen die Basisanschlüsse der Transistoren T3 und T6 am Kollektor des Transistors T1 und die Basisanschlüsse der Transistoren T4 und T5 der Mischstufe am Kollektor des anderen Transistors T2 des Oszillators.

Die zur Beaufschlagung der Emitter des ersten Transistorpaares T3, T4 einerseits und des zweiten Transistorpaares T5, T6 der Mischstufe vorgesehenen npn-Transistoren T7 und T8 dienen ihrerseits als Signaleingang der Mischstufe und damit der Schaltung. Sie werden deshalb im Betrieb durch ein extremes Signal, das z. B. von einem (nicht dargestellten) Eingangsverstärker geliefert wird, gesteuert. Hierzu ist die Basis des Transistors T7 mit der einen Eingangsklemme E1 und die Basis des anderen Transistors T8 mit der anderen Eingangsklemme E2 verbunden. Schließlich liefern die beiden Transistoren T7 und T8 das für die Transistorpaare T3, T4 und T5, T6 der Mischstufe erforderliche Emitterpotential. Hierzu ist eine weitere Gleichspannungsquelle U2 vorgesehen, deren einer Pol auf dem gemeinsamen Bezugspotential liegt, während der andere Pol einerseits über einen Widerstand R5 an die Basis des Transistors T7 und über einen Widerstand R6 andererseits an die Basis des Transistors T8 gelegt ist.

Wesentlich für die Erfindung ist nun, daß jeder der beiden Ausgänge des Oszillators, also die Kollektoren der beiden Transistoren T1 und T2, über je einen Widerstand R9 bzw. R10 an je einen Eingang eines Regelverstärkers V, also eines Differenzverstärkers, gelegt und außerdem der dem Transistor T1 bzw. T2 abgewandte Anschluß des Widerstands R9 bzw. R10 über einen Kondensator C4 verbunden ist. Damit bildet der Widerstand R9 und der Widerstand R10 mit dem Kondensator C4 einen Tiefpaß, der zur Steuerung je eines der beiden Eingänge des Regelverstärkers dient.

Der Signalausgang des Regelverstärkers V liegt unmittelbar an der Basis des nicht unmittelbar an dem Kondensator C1 und damit über diesem an dem frequenzbestimmenden Steuerorgan des Oszillators liegenden Transistors T2.

Der Tiefpaß R9 und R10, C4 wird so dimensioniert, daß das Erscheinen der Oszillatorschwingung am Eingang des Regelverstärkers V völlig unterdrückt wird. Dies bedingt, daß die Gegenkopplung, die durch die beschriebene Schaltung bewirkt wird, rein gleichstrommäßig ist. Die Folge davon ist, daß die im Prinzip unvermeidbare Unsymmetrie der Potentialänderungen an den beiden Ausgangsklemmen des Oszillators und damit an den beiden Eingängen T3, T6 und T4, T5 vermindert wird. Dies wirkt sich im Sinne einer Unterdrückung des Oszillatorrauschens sowie einer Kompensation weiterer vom Oszillator herrührender Störungen auf das vom Ausgang der

Mischstufe A1, A2 gelieferte ZF-Signal aus, so daß die vorgesehene Gegenkopplung am Oszillator einwandfrei eine erhebliche Verbesserung im Vergleich zu Schaltungen bedeutet, die die der Erfindung entsprechende Maßnahme nicht verwenden.

Der Regelverstärker V ist zweckmäßig als Operationsverstärker ausgebildet.

Die in Fig. 2 dargestellte Schaltung einer Oszillator-Mischer-Kombination in Bipolartechnik enthält im Prinzip dieselben Schaltungsteile, wie sie in dem Schaltbild gemäß Fig. 1 angegeben sind. Jedoch ist die Schaltung wesentlich detaillierter. Sie besteht in der Hauptsache aus npn-Transistoren nebst einigen pnp-Transistoren, sowie aus Dioden, Kapazitäten und Widerständen, so daß, wenn man vom Schwingkreis absieht, die übrige Schaltung sich ohne weiteres monolithisch zusammenfassen läßt. Zusätzlich zu den aus Fig. 1 ersichtlichen Schaltungsteilen sind unter anderem der Verbesserung der angestrebten Wirkung sowie des Betriebs des Oszillators und der Mischstufe dienende Konstantstromquellen vorgesehen.

Der in dem in Fig. 2 gezeichneten Beispielsfall als Parallelschwingkreis ausgebildete und der Festlegung der Oszillatorfrequenz dienende Schwingkreis liegt über den beiden Koppelkondensatoren 28 und 29 an dem Steuereingang des Oszillators. Der Oszillator ist wiederum durch zwei npn-Transistoren 33, 41 gegeben, die den Transistoren T1 und T2 gemäß Fig. 1 entsprechen und mit ihren Emittern verbunden sind. Der mit seinem anderen Anschluß am Bezugspotential (Masse) liegende Schwingkreis 25 liegt mit seinem ersten Anschluß über den Kondensator 28 am Kollektor des Transistors 33 und über den Kondensator 29 an der Basis des Transistors 41. Dieser ist außerdem über einen aus den beiden Widerständen 68, 69 bestehenden Spannungsteiler mit der Basis des Transistors 33 des Oszillators verbunden. Der Teilerpunkt dieses Spannungsteilers 68, 69 ist an das von einer Gleichspannungsquelle U3 gelieferte dritte Betriebspotential gelegt. Die Kathode der Diode 31 ist mit der Basis des Transistors 33 und andererseits über einen Widerstand 30 an den Ausgang eines noch zu beschreibenden und als Stromquelle dienenden Schaltungsteils gelegt, während die Anode der Diode 31 am Bezugspotential liegt.

Der Kollektor des Oszillatortransistors 33 sowie der Kollektor des Oszillatortransistors 41 liegt über je einen Widerstand 34 bzw. 38 am Emitter je eines Transistors 35 bzw. 39 vom npn-Typ, deren Kollektoren über je einen Widerstand 36 bzw. 37 an das von einer Gleichspannungsquelle U1 gelieferte erste Betriebspotential gelegt sind. Das erste Betriebspotential wird von der positiven Klemme und das Bezugspotential von der negativen Klemme der Gleichspannungsquelle U1 geliefert. Für die Erzeugung des Potentials der Basisanschlüsse der beiden der Signalentkopplung des Oszillatorsignals dienenden Transistoren 35 und 39 sind diese über einen Widerstand 40 an den positiven Pol einer weiteren Gleichspannungsquelle U4 gelegt, die mit ihrem negativen Pol ebenfalls auf Masse bezogen ist. Die beiden Kaskodetransistoren 35 und 39 bilden mit ihren Kollektoren die beiden Ausgangsanschlüsse des Oszillators.

Um den Oszillator auch an das Bezugspotential anzuschließen sind die Emitter der beiden Oszillatortransistoren 33 und 41 an den Kollektor eines npn-Transistors 43 gelegt, dessen Emitter mit dem Emitter zweier weiterer ebenfalls als Stromquelle dienender Transistoren 44 und 45 (ebenfalls vom npn-Typ) zusammengefaßt und über die Kollektor-Emitterstrecke eines weiteren npn-Transistors 54 und den Widerstand 55 an das Bezugspotential gelegt ist. Dabei ist der Kollektor des Stromversorgungstransistors 44 mit dem Kollektor des Oszillatortransistors 33 und der Kollektor des Transistors 45 mit dem Kollektor des Oszillatortransistors 41 verbunden. Auf die der Erzeugung der Basispotentiale der Transistoren 43, 44 und 45 dienenden Schaltungsmittel wird weiter unter noch eingegangen.

Die Ausgangsanschlüsse des Oszillators, also die Kollektoren der npn-Transistoren 35 und 39 sind sowohl für die gemäß der Erfindung vorzunehmende Rückkopplung als auch für die Beaufschlagung der Mischstufe vorgesehen. Zu diesem Zweck ist der Kollektor des Transistors 35 mit der Basis eines npn-Transistors 120 und der Kollektor des Transistors 39 mit der Basis eines npn-Transistors 121 verbunden. Die Kollektoren dieser beiden Transistoren 120 und 121 liegen am ersten Betriebspotential, also am positiven Pol der Spannungsquelle U1 und ihre Emitterelektroden über je einen (gleichbemessenen) Widerstand 64 und 63, die ihrerseits miteinander verbunden und über einen weiteren Widerstand 24 an das Bezugspotential der Schaltung gelegt sind. Die Emitter der beiden als Emitterfolger für die Mischstufe dienenden npn-Transistoren 120, 121 sind an die für die Beaufschlagung durch den Oszillator vorgesehenen Eingänge der symmetrischen Mischstufe gelegt.

Die Mischstufe besteht aus den npn-Transistoren 107, 108, 109, 110, 111, 112 und 106 und 105, sowie den Widerständen 104, 122 und 123. Die Transistoren 107 und 108 bilden das erste Transistorpaar und die Transistoren 109 und 110 das zweite Transistorpaar entsprechend der in Fig. 1 gebrachten Schaltung für die symmetrische Mischstufe. Die Zusammenfassung der Transistoren 107 und 108 bzw. 109 und 110 ist wiederum durch die Verbindung der Emitter der Transistoren des betreffenden Transistorpaares sowie deren Beaufschlagung durch den Kollektor je eines dem betreffenden Paar zugeordneten npn-Transistors 106 bzw. 105. Ebenso wie in Fig. 1 die Transistoren T7 und T8 sind die durch das extern über den Signaleingang 113 mit dem zu verarbeitenden Signal über ihre Basisanschlüsse zu steuernden Transistoren 105 und 106 außerdem durch eine weitere Gleichspannungsquelle U2 über je einen Widerstand 122 bzw. 123 mit der erforderlichen Basisspannung versehen, während die Emitter dieser beiden Transistoren 105 und 106 über einen gemeinsamen Widerstand 104 am Bezugspotential liegen.

Der Transistor 107 des ersten und der Transistor 110 des zweiten Transistorpaares der Mischstufe wird über den Emitter des als Emitterfolger betriebenen Transistors 120 durch das Oszillatorsignal gesteuert. Andererseits erfolgt die Steuerung des Transistors 108 des ersten und des Transistors 109 des zweiten Paares der Mischstufe durch den Emitter des Transistors 121. Der Emitter des Transistors 121 liegt außerdem über einen Widerstand 27 an der Basis der weiter unten noch zu beschreibenden Schaltung aus den Transistoren 11 und 12.

Die Kollektoren des Transistors 107 und des Transistors 109 der Mischstufe steuern gemeinsam den Emitter des Ausgangstransistors 111 (vom npn-Typ) und andererseits die Kollektoren der beiden Transistoren 108 und 110 der Mischstufe steuern gemeinsam den Emitter des zweiten Ausgangstransistors 112 (ebenfalls vom npn-Typ) der Mischstufe. Die Kollektoren der beiden Ausgangstransistoren bilden den Signalausgang 114 der Schaltung. Die Basisanschlüsse der beiden Ausgangstransistoren 111 und 112 sind gemeinsam über den Widerstand 42 an das Bezugspotential der Schaltung gelegt.

Um die gemäß der Erfindung vorgesehene Gegenkopplung des Oszillators zu erhalten, ist der Kollektor des Oszillatortransistors 33 mit der Basis eines npn-Transistors 70 und der Kollektor des Oszillatortransistors 41 mit der Basis eines npn-Transistors 73 verbunden. Die beiden zuletzt genannten Transistoren 70 und 73 sind als Emitterfolger betrieben und liegen deshalb mit ihren Kollektoren am ersten von der Spannungsquelle U1 gelieferten Betriebspotential, während ihre Emitter über je einen Widerstand 71 und 72 (gleichbemessen) und einen dritten — gemeinsamen — Widerstand 65 am Bezugspotential der Schaltung liegen. Außerdem dienen die Emitter dieser beiden npn-Transistoren 70 und 73 zur Steuerung zweier Transistorkombinationen. Zu diesem Zweck ist der Emitter des Transistors 70 einerseits mit der Basis eines npn-Transistors 67 und über einen Widerstand 85 mit der Basis eines weiteren npn-Transistors 83 verbunden, während der Emitter des Transistors 73 an der Basis eines npn-Transistors 74 und über einen Widerstand 84 an der Basis des bereits genannten Transistors 83 liegt.

Der npn-Transistor 83 ist mit einem weiteren npn-Transistor 82 zu einer Darlington-Stufe zusammengefaßt, indem sein Emitter mit der Basis des Transistors 82 und sein Kollektor mit dem Kollektor des Transistors 82 unmittelbar verbunden ist. Die Kollektoren der Transistoren 82, 83, 74 und 67 liegen am ersten Betriebspotential, also am Pluspol von U1. Die Emitter der npn-Transistoren 67 und 74 sind ebenfalls miteinander verbunden und liegen an der Kathode der Diode 62 (die einen Kondensator bildet), deren Anode am Bezugspotential liegt. Der Emitter des Transistors 82, also der Eingang der besagten Darlington-Schaltung, ist mit der Basis eines pnp-Transistors 86 verbunden, dessen Kollektor am Bezugspotential und dessen Emitter an der Kathode einer Diode 87 liegt, die mit ihrer Anode mit der Basis eines Zwei-Kollektor-pnp-Transistors 88 verbunden ist. Der eine Kollektor dieses Transistors 88 ist unmittelbar an die Basis dieses Transistors 88 gelegt, dessen zweiter Kollektor über die Kollektor-Emitterstrecke eines npn-Transistors 96 und einem mit dem Emitter dieses Transistors 96 verbundenen Widerstandes 98 an das Bezugspotential gelegt ist.

Der Emitter des genannten Zwei-Kollektor-Transistors 88 ist einerseits über einen Widerstand 90 mit dem Kollektor eines weiteren pnp-Transistors 115 als auch über einen weiteren dem Widerstand 90 gleichen Widerstand 91 mit dem Emitter eines zweiten pnp-Zwei-Kollektor-Transistors 92 verbunden. Die Anschaltung der beiden Kollektoren und der Basis des Transistors 92 entspricht den Verhältnissen beim Zwei-Kollektor-Transistor 88. Demzufolge sind der eine Kollektor und die Basis miteinander unmittelbar verbunden und liegen an der Anode einer Diode 94, deren Kathode mit dem Emitter eines weiteren pnp-Transistors 93 verbunden ist. Der Kollektor des zuletzt genannten pnp-Transistors 93 liegt am Bezugspotential. Der zweite Kollektor des pnp-Transistors 92 ist über die Kollektor-Emitterstrecke eines dem Transistor 96 entsprechenden npn-Transistors und einem dem Widerstand 98 gleichen Widerstand 97 an das Bezugspotential gelegt. Beide npn-Transistoren 95 und 96 bilden eine basisgekoppelte Stromquelle.

Der im letzten Absatz genannte und zur Steuerung der Emitter der beiden Zwei-Kollektor-Transistoren 88 und 92 vorgesehene pnp-Transistor 115 ist mit seinem Emitter über einen Widerstand 119 einerseits mit dem von U1 gelieferten ersten Betriebspotential verbunden. Der Emitter des pnp-Transistors 116 liegt über den Widerstand 118 an dem von der Gleichspannungsquelle U1 gelieferten ersten Betriebspotential. Die Basis dieses weiteren pnp-Transistors 116 liegt über den Widerstand 117 sowohl an der Basis des pnp-Transistors 115 als auch am eigenen Kollektor.

Der Kollektor des zuletzt vorstellten pnp-Transistors 116 und damit die Basis des pnp-Transistors 115 sind über die Kollektor-Emitterstrecke eines pnp-Transistors 99 und einem mit dem Emitter dieses Transistors 99 verbundenen Widerstand 100 an das Bezugspotential der Schaltung geschaltet.

Der soeben eingeführte npn-Transistor 99 bildet mit einem weiteren npn-Transistor 22 zusammen eine Konstantstromquelle. Hierzu liegt der Kollektor des npn-Transistors 22 über einen Widerstand 103 an dem von U1 gelieferten ersten Betriebspotential und mit seinem Emitter über den Widerstand 102 am Bezugspotential, während die Basis des Transistors 22 über einen Widerstand 101 sowohl mit dem eigenen Kollektor als auch mit der Basis des npn-Transistors 99 verbunden ist. Der Widerstand 103 dient außerdem in noch zu beschreibender Weise zur Steuerung der Stromversorgung der Oszillatortransistoren 33 und 41.

Der mit dem Kollektor des npn-Transistors 96 verbundene Kollektor des bereits vorgestellten Zwei-Kollektor-pnp-Transistors 88 liegt außerdem an der Anode einer Diode 23, deren Kathode an die Basis des zu der bereits genannten Darlington-Stufe gehörenden npn-Transistors 83 gelegt ist. Außerdem liegt der besagte Kollektor des Zwei-Kollektor-pnp-Transistors 88 an der Basis eines pnp-Transistors 57 sowie über den Widerstand 59 am positiven Pol einer weiteren Gleichspannungsquelle U3, die bereits in Verbindung mit der Steuerung des Oszillators über den die Basisanschlüsse der Transistoren 33 und 41 verbindenden Spannungsteiler 68, 69 genannt wurde.

Der durch die Kollektoren des Zwei-Kollektor-Transistors 88 und des Transistors 96 gesteuerte pnp-Transistor 58 liegt mit seinem Kollektor am Bezugspotential und mit seinem Emitter an der Basis eines ersten npn-Transistors 57 sowie am Emitter eines weiteren npn-Transistors 56. Der Kollektor dieser beiden Transistoren 56 und 57 liegt an dem von der Gleichspannungsquelle U1 gelieferten ersten Betriebspotential. Die Transistorkombination 56, 58 dient zur Klemmung der maximal möglichen Spannung an der Basis 57. Der Emitter des npn-Transistors 57 ist mit der Basis der bereits im Zusammenhang mit den Oszillatortransistoren 33 und 41 erwähnten npn-Transistoren 44 und 45 verbunden.

Die Emitter der am Eingang des Gegenkopplungszweiges des Oszillators vorgesehenen und bereits genannten npn-Transistoren 70 und 73 sind wie bereits erwähnt zur Steuerung dreier npn-Transistoren 67, 74 und 83 vorgesehen. Die Emitter der beiden Transistoren 67 und 74 sind zusammengeschaltet und liegen an der Kathode einer Diode 62, deren Anode auf dem Bezugspotential gehalten ist. Eine weitere Diode 61 liegt mit der Anode ebenfalls am Bezugspotential und mit der Kathode an der Basis des npn-Transistors 83 und damit am Eingang der Darlington-Stufe aus den Transistoren 82 und 83. Ferner sind die Emitter der beiden npn-Transistoren 67 und 74 mit der Basis eines npn-Transistors 66 verbunden, dessen Kollektor am ersten Betriebspotential (geliefert von U1) und dessen Emitter am Kollektor und Emitter eines weiteren npn-Transistors 75 sowie über einen Widerstand 79 sowohl an der Basis des bereits im Zusammenhang mit dem zweiten Zwei-Kollektor-Transistors 92 erwähnten pnp-Transistors 93 als auch über einen weiteren Widerstand 80 am Kollektor eines weiteren npn-Transistors 77 liegt. Der Kollektor des zuletzt genannten npn-Transistors 77 ist zudem über einen Widerstand 76 mit dem Emitter des als Diode geschalteten npn-Transistors 75 verbunden.

Der Emitter des zuletzt eingeführten npn-Transistors 77 liegt über einen Widerstand 78 am Bezugspotential. Die Basis dieses Transistors ist mit der Basis des bereits im Zusammenhang mit der Darlington-Stufe aus den npn-Transistoren

82, 83 eingeführten und deren Emitter zum Bezugspotential führenden npn-Transistors 81 verbunden. Beide Basisanschlüsse werden über eine fünfte Gleichspannungsquelle U5, deren negativer Pol am Betriebspotential liegt, versorgt.

Eine weitere Konstantstromquelle besteht aus den basisgekoppelten npn-Transistoren 3 und 4, wobei der Emitter des Transistors 3 unmittelbar und der Emitter des Transistors 5 über den besagten Widerstand 5 an das Bezugspotential der Schaltung gelegt ist. Der Kollektor des Transistors 3 ist mit der eigenen Basis und über einen Widerstand 1 an das erste Betriebspotential geschaltet. Der Kollektor des zweiten Transistors 4 der Stromquelle (also deren Ausgang) liegt am Kollektor eines weiteren pnp-Transistors 6, dessen Emitter über einen Widerstand 2 am ersten Betriebspotential und dessen Basis über einen Widerstand 7 mit der Basis eines weiteren pnp-Transistors 9 verbunden ist. Ein Widerstand 8 bildet die Verbindung des Emitters dieses weiteren pnp-Transistors 9 mit dem ersten Betriebspotential. Der Kollektor des pnp-Transistors 9 ist mit dem Kollektor zweier weiterer npn-Transistoren 11 und 12 verbunden.

Die Basis des ersten dieser npn-Transistoren, also des Transistors 11, führt über den Widerstand 26 an den Basisanschluß des Transistors 107 und den Basisanschluß des Transistors 110 der Mischstufe und somit an deren durch den Oszillator zu beaufschlagenden Signaleingang. Die Basis des zweiten dieser npn-Transistoren, nämlich des Transistors 12, führt über den Widerstand 27 an die Basisanschlüsse der Transistoren 108 und 109, und damit ebenfalls an denjenigen Eingang der symmetrischen Mischstufe, der vom anderen Ausgang des Oszillators gesteuert wird.

Die Basisanschlüsse der zuletzt eingeführten npn-Transistoren 11 und 12 sind noch vor den Widerständen 26 und 27 durch zwei, die gewünschte Tiefpaßwirkung ergebende Dioden überbrückt. Dabei ist die Basis des Transistors 11 mit der Anode der Diode 21 und die Kathode dieser Diode 21 mit der Basis des npn-Transistors 12 verbunden. Bei der Diode 20 ist die Anode mit der Basis des npn-Transistors 12 und die Kathode mit dem Pol der Basis des Transistors 11 unmittelbar verbunden.

Die Kollektoranschlüsse der npn-Transistoren 11 und 12 werden, wie bereits erwähnt, gemeinsam vom Transistor 9 der die Transistoren 3, 4, 6 und 9 enthaltenden Konstantstromquelle versorgt.

Der Signalausgang der beiden npn-Transistoren 11 und 12 ist durch deren Emitteranschlüsse gegeben, die zu diesem Zweck mit dem Emitter je eines pnp-Transistors 13 bzw. 14 verbunden sind. Die Basis des pnp-Transistors 13 und des pnp-Transistors 14 ist unmittelbar mit dem Kollektor des bereits genannten Stromversorgungstransistors 4 verbunden. Die Kollektoren der beiden zuletzt genannten pnp-Transistoren 13 und 14 liegen über die Kollektor-Emitterstrecke je eines npn-Transistors 17 bzw. 18 und einem dem Emitter des betreffenden Transistors 17 bzw. 18 vorgeschalteten Widerstand 19 bzw. 16 am Bezugspotential der Schaltung. Außerdem sind die beiden Transistoren 17 und 18 mit ihren Basisanschlüssen unmittelbar verbunden, wobei außerdem die Basis des Transistors 18 zum eigenen Kollektor kurzgeschlossen und so dieser Transistor 18 als Diode geschaltet ist. Schließlich ist die Basis der beiden npn-Transistoren 17 und 18 an die Anode einer Diode 15 gelegt, deren Kathode an den Kollektor des npn-Transistors 17 und damit an den Kollektor des pnp-Transistors 13 geschaltet ist. Außerdem sind die Kollektoren der Transistoren 17 und 13 über den bereits genannten Widerstand 30 an die Basis des Oszillatortransistors 33 und damit an den Oszillator rückgekoppelt.

Die bereits wiederholt im Zusammenhang mit den beiden Oszillatortransistoren 33 und 41 genannten npn-Transistoren 45 und 46 erhalten — ebenso wie der Emitter des ebenfalls bereits vorgestellten npn-Transistors 43 — ihr Betriebspotential vom Kollektor eines npn-Transistors 54, dessen Emitter über einen Widerstand 55 durch das Bezugspotential beaufschlagt ist. Ein weiterer npn-Transistor 52 ist mit seinem Emitter über den Widerstand 53 ebenfalls an das Bezugspotential gelegt, während sein Kollektor einerseits mit der Basis des bereits oben erwähnten npn-Transistors 44 bzw. 45 und mit dem Emitter eines weiteren npn-Transistors 57 verbunden ist. Die drei npn-Transistoren 48, 52 und 54 liegen mit ihren Basisanschlüssen sämtlich am Kollektor des Stromversorgungstransistors 22 und damit auch am Widerstand 103, der die Verbindung zum ersten Betriebspotential (Gleichspannungsquelle U1) der Schaltung herstellt. Der npn-Transistor 46 liegt ebenfalls mit seinem Kollektor am ersten Betriebspotential, während das Basispotential dieses Transistors 46 mit dem Basispotential des bereits im Zusammenhang mit den npn-Transistoren 56 und 57 erwähnten pnp-Transistors 58 und dem Basispotential des npn-Transistors 56 identisch ist und am positiven Pol der Gleichspannungsquelle U3 liegt.

Damit ist die in Fig. 2 dargestellte und mit Ausnahme des Schwingkreises 25 ohne Schwierigkeiten monolithisch integrierbare Schaltung einer Oszillator-Mischerstufe gemäß der Erfindung voll beschrieben.

Hinsichtlich der Wirkungsweise ist nun folgendes festzustellen:

Der Regelverstärker in der Rückkopplung des Oszillators ist durch den Eingangstransistor 86, die Diode 87, die beiden Zwei-Kollektor-Transistoren 88 und 92, die Diode 94 und den Transistor 93 sowie die npn-Transistoren 95 und 96 gegeben. Der Eingang der Rückkopplung ist, wie bereits oben bemerkt, durch die beiden Transistoren 70 und 73 gegeben.

Von Emitter der beiden Transistoren 70 und 73 wird über die beiden Widerstände 84 und 85 an die Basis des Transistors 83 das gegenphasige Signal zu dem Signal an den Emittern der beiden Transistoren 70 und 73 durch Aufsummierung erzeugt. Restkomponenten werden dabei über die Diode 61 geerdet, so daß die beiden Widerstände 84 und 85 in Kombination mit der Diode 61 als Tiefpaß wirken. Man bekommt dabei den Referenzwert an der Basis des Transistors 83. Dieser Referenzwert wird über den Emitter des Transistors 83, die Basis des Transistors 82 und den Emitter des Transistors 82 an den Eingangstransistor des Regelverstärkers, also die Basis des pnp-Transistors 86, weitergegeben.

Das hierzu gegenphasige Signal an den Emittern der Transistoren 70 und 73 wird ebenfalls an die Basis der Transistoren 67 und 74 geleitet. Der Emitter dieser Transistoren 67 und 74 ist über die Diode 62 kapazitiv gegen Masse, also das Bezugspotential, abgeblockt und wird bezüglich der erforderlichen Emitterspannung von der Basis des Transistors 66 her versorgt. An der Diode 62 bildet sich nun dank der Spitzenwertgleichrichtung der Transistoren 67 und 74 ein zusätzliches Gleichspannungspotential nach Maßgabe der Oszillatoramplitude aus. Dieses Potential wird über den Emitter des Transistors 66 an die kurzgeschlossene Basis-Kollektorstrecke des Transistors 75 weitergeleitet. Der Emitter des Transistors 75 wird über den Widerstand 76 vom Kollektor des Transistors 77 mit dem erforderlichen Betriebsstrom versorgt.

Der Emitter des Transistors 66 liegt am Widerstand 79. Von diesem Widerstand 79 geht der Widerstand 80 ab auf den Kollektor des Transistors 77 und den Widerstand 76 zum Emitter des Transistors 75. Durch das Verhältnis der Widerstandswerte in den Teilern 79 und 80 wird ein Gleichspannungswert eingestellt, der proportional der Spannungsänderung an den Emittern der Transistoren 67 und 74 ist. Dadurch bekommt der Regelverstärker seinen Vorhalt. Der Vorhalt des Regelverstärkers wird über die Spannungsteiler 79 und 80 eingestellt und damit auch die Ozillatoramplitude.

Die im Oszillator vorgesehenen Ausgangstransistoren 35 und 39 dienen dazu, dafür zu sorgen, daß die Störungen, die vom Eingang 113 der Mischstufe herrühren und am Kollektor dieser Ausgangstransistoren anliegen, infolge der geringen Kollektor-Emitterrückwirkung der Transistoren 35, 39 sich nur stark abgeschwächt auf den Oszillatorkreis bemerkbar machen können.

Das Signal an der Basis der Transistoren 11 und 12 wird über die Kaskodenstufe 13 und 14 und den Stromspiegel 17, 18 verstärkt. Durch die aus Fig. 2 ersichtliche und oben beschriebene Zusammenschaltung der Transistoren 13 und 17 bzw. 14 und 18 bilden die Kollektoren der Transistoren 13 und 17 einen Gegentakt-Stromausgang, der über den Widerstand 30 und den Lastwiderstand 68 steuernd auf die Basis des Oszillatortransistors 33 einwirkt. Um Regelschwingungen zu unterdrücken, dienen die Dioden 31 und 15. Die Dioden 20 und 21 schließen das gegenphasige Signal am Ausgang der Widerstände 26 und 27 kurz. Dadurch werden nur die Gleichstromkomponente und höchstens noch Komponenten sehr niedriger Frequenz an den Regelverstärker 11, 12 gelassen.

Der Regelverstärker 86, 87 dient der Aufgabe, die Oszillatoramplitude über den Gegentakt-Stromausgang, der durch die Kollektoren der Transistoren 88 und 96 gegeben ist, zu regeln, und zwar über die Basis des Transistors 57. Der die Spannung einstellende Lastwiderstand ist durch den Widerstand 59 gegeben. Der Regelverstärker 11, 12 usw. hingegen hat die Aufgabe, die Unsymmetrie am Mischer zu vermindern.

Die weitere Erfindung bezieht sich in der Hauptsache auf eine weitere Verbesserung der bisher beschriebenen Transistor-Oszillatorschaltung. Die weitere Erfindung bringt aber auch dann Vorteile, wenn sie auf einen schwingkreis- oder quarzgesteuerten Oszillator, der durch einen rückgekoppelten Differenzverstärker gegeben ist, angewendet wird, selbst dann, wenn der besagte Oszillator nicht zur Beaufschlagung einer Mischstufe vorgesehen ist.

Um einen Differenzverstärker als den aktiven Teil eines Oszillators einzusetzen und zu betreiben, kann man entsprechend dem in »Funkschau« (1971) Heft 15, S. 465 und 466, veröffentlichten Aufsatz mit dem Titel »Zweipolige Oszillatorschaltungen für Parallel- und Serienresonanz« vorgehen. Solche Schaltungen lassen sich z. B. in der Rundfunktechnik oder in der Fernsehtechnik einsetzen. Im allgemeinen arbeiten derartige Oszillatoren durchaus zufriedenstellend.

Verwendet man aber einen solchen Oszillator zur Beaufschlagung einer Mischstufe, insbesondere bei einer integrierten Oszillator-Tuner-Mischerschaltung, so wird bei Anwendung der üblichen Aufbaumethoden für eine solche Schaltung bei weitem nicht das Optimum hinsichtlich der Unterdrückung des Eingangssignals bzw. des Oszillatorsignals auf den Ausgang der Mischstufe und damit auf die Wiedergabequalität des eine solche Oszillatorschaltung verwendenden Rundfunk- oder Fernsehempfängers erreicht. Auch hinsichtlich der Unterdrückung des sog. Oszillatorrauschens sind die bekannten Schaltungen dieser Art verbesserungsbedürftig.

Zur Lösung dieser Aufgaben wurde die bisher beschriebene und der Definition zu Beginn dieser Beschreibung entsprechende Oszillatorschaltung entwickelt. Jedoch ist aber auch eine solche Oszillatorschaltung im Interesse einer Verminderung der Frequenzdrift sowie einer Vergrößerung des Durchstimmbereiches und einer Erhöhung der Schwingsicherheit weiter verbesserungsfähig, was übrigens auch für die bekannten auf Basis von Differenzverstärkern beruhenden Oszillatorschaltungen gilt.

Zur Lösung der genannten Aufgaben ist gemäß der Erfindung weiters vorgesehen, daß der Kondensator im frequenzbestimmenden Steuerorgan mit seinem einen Anschluß an dem zum ersten Transistor des Differenzverstärkers führenden ersten Koppelkondensator und mit seinem zweiten Anschluß an den zum Kollektor des zweiten Transistors des Differenzverstärkers führenden zweiten Koppelkondensator unmittelbar angeschlossen ist, daß dabei ein weiterer Kondensator im frequenzbestimmenden Steuerorgan vorgesehen ist, derart, daß dieser weitere Kondensator mit seinem einen Anschluß mit dem vom zweiten Transistor des Differenzverstärkers abgewandten Anschluß des zweiten Koppelkondensators unmittelbar als auch über einen Widerstand mit dem einen Pol einer dritten Gleichspannungsquelle verbunden ist, während der andere Anschluß dieses weiteren Kondensators im frequenzbestimmenden Steuerorgan sowie der andere Pol der dritten Gleichspannungsquelle unmittelbar an der das Bezugspotential führenden Versorgungsklemme der Oszillatorschaltung liegen.

Eine in diesem Sinne verbesserte Transistor-Oszillatorschaltung ist in Fig. 3 dargestellt, während die in Fig. 4 dargestellte Oszillatorschaltung zusätzlich der bisher beschriebenen der Transistor-Oszillatorschaltung entspricht.

Die beiden, den Oszillator bei der Schaltung gemäß Fig. 3 und Fig. 4 bildenden Bipolartransistoren T1 und T2 sind einander gleich und vom npn-Typ. Sie sind mit ihren Emittern unmittelbar verbunden und diese Emitter über einen gemeinsamen Widerstand R1 an die das Bezugspotential führende Versorgungsklemme der Schaltung, also an Masse, gelegt. Der das erste Betriebspotential zur Verfügung stellende Versorgungsanschluß der Oszillatorschaltung ist mit dem positiven Pol, der das Bezugspotential liefernde Anschluß der Oszillatorschaltung ist mit dem negativen Pol einer ersten Gleichspannungsquelle U1 unmittelbar verbunden.

Die Basis des ersten Transistors T1 des Differenzverstärkers bildet den an das frequenzbestimmende Organ angeschlossenen Steuereingang des Oszillators, wobei zwischen diesen beiden Schaltungsteilen ein erster Koppelkondensator C1 vorgesehen ist. Das genannte frequenzbestimmende Steuerorgan ist entweder ein Parallel-Resonanzkreis (also ein aus einem Kondensator mit parallelgeschalteter Induktivität gebildeter Schwingkreis), der einerseits an die das Bezugspotential führende Versorgungsklemme und andererseits an den zur Basis des ersten Transistors T1 des Differenzverstärkers führenden ersten Koppelkondensator C1 angeschlossen ist.

In Alternative hierzu kann das besagte Steuerorgan durch einen seriellen Schwingkreis gegeben sein. Dann wird die parallel zum Schwingkreiskondensator bei den Schaltungen gemäß Fig. 3 und Fig. 4 gelegte Induktivität L durch eine — dann die einzige Verbindung zwischen den von den Transistoren des Differenzverstärkers T1 und T2 abgewandten Anschlüssen der beiden Kopplungskondensatoren C1 und C2 bildende — Induktivität ersetzt. Schließlich kann man auf eine Induktivität im Steuerorgan völlig verzichten und stattdessen die beiden Anschlüsse eines Schwingquarz-Kondensators an je einen der beiden nicht mit einem der Transistoren T1 oder T2 verbundenen Anschluß des ersten und des zweiten Koppelkondensators C1 und C2 legen. Eine besonders vorteilhafte Anschaltung des Schwingquarzkondensators wird noch weiter unten als eine weitere Ausgestaltung eines Oszillators gemäß der Erfindung beschrieben.

Während bei den üblichen Oszillatorschaltungen und auch bei der anhand von Fig. 1 und 2 beschriebenen Oszillatorschaltung im frequenzbestimmenden Steuerkreis nur ein Kondensator C vorgesehen ist, ist stattdessen im Falle der Weiterbildung der Erfindung die Serienschaltung zweier Kondensatoren C' und C* vorgesehen und in einer noch zu beschreibenden sowie der Definition der Erfindung entsprechenden Weise angeschaltet.

Die Basis des ersten Transistors T1 des Differenzverstärkers ist über zwei hintereinandergeschaltete Widerstände R3 und R2 mit der Basis des zweiten Transistors T2 des Differenzverstärkers verbunden. Der Teilerpunkt zwischen diesen beiden Widerständen R2 und R3 ist mit dem positiven Pol der zweiten Gleichspannungsquelle gemäß der Definition der Erfindung, also der Gleichspannungsquelle U3, verbunden, während der andere Pol dieser Gleichspannungsquelle an der das Bezugspotential führenden Versorgungsanschlußklemme, also den negativen Pol der Gleichspannungsquelle U1, angelegt ist. Ein weiterer Kondensator C3 ist zwischen dem Basisanschluß des zweiten Transistors T2 des Differenzverstärkers und der das Bezugspotential führenden Versorgungsklemme vorgesehen. Aufgrund der die Oszillatorwirkung des Differenzverstärkers T1, T2 bewirkenden Rückkopplung zwischen dem Basisanschluß des Transistors T1 und dem Kollektoranschluß des Transistors T2 sind die Kollektoren dieser beiden Oszillatortransistoren T1 und T2 imstande, gemeinsam eine ungedämpfte Sinusschwingung abzugeben. Sie bilden demgemäß die beiden Ausgangsklemmen A1* und A2* des Oszillators gemäß Fig. 1. Im Falle der Schaltung gemäß Fig. 2 sind diese beiden Ausgangsklemmen A1* und A2* an zwei Eingangstransistoren T3 und T6 der zu beaufschlagenden Mischstufe angeschlossen.

Wie bereits dargelegt, ist in der Steuerschaltung eines der Erfindung entsprechenden Transistoroszillators die Serienschaltung zweier Kondensatoren C' und C* vorgesehen. Diese beiden Transistoren C' und C* bilden zusammen einen kapazitiven Spannungsteiler.

Für den Fall, daß als frequenzbestimmendes Steuerorgan des Oszillators ein Parallel-Resonanzkreis vorgesehen ist, bildet die Schwingkreisinduktivität L eine Verbindung zwischen den beiden Endanschlüssen des Spannungsteilers C', C*, welche die beiden Kondensatoren sammt dem Teilerpunkt überbrückt und außerdem mit dem einen Anschluß an der das Bezugspotential führenden Versorgungsklemme liegt. Im Falle eines Serien-Resonanzkreises entfällt diese Induktivität L. Stattdessen wird eine die beiden Koppelkondensatoren C1 und C2 überbrückende Induktivität vorgesehen. Soll der Oszillator stattdessen durch einen Schwingquarz gesteuert werden, so tritt der den Schwingquarz als Dielektrikum enthaltende Kondensator an die Stelle der im Falle der Verwendung eines Serien-Resonanzkreises zu verwendenden Induktivität. In allen Fällen ist jedoch der aus den beiden Kondensatoren C' und C* gebildete Spannungsteiler vorgesehen, wobei die Anschaltung dieses Spannungsteilers an die beiden Kopplungskondensatoren C1 und C2, an das Bezugspotential, an den Widerstand R* und die Gleichspannungsquelle U* stets der aus Fig. 1 und Fig. 2 ersichtlichen Ausgestaltung entspricht. Dasselbe gilt auch, wenn im Falle einer besonders vorteilhaften Art der Schwingquarzsteuerung der zweite Koppelkondensator C2 durch einen Schwingquarz gegeben ist.

Wie aus Fig. 3 und 4 ersichtlich, liegt der erste Kondensator des Spannungsteilers C' mit seinem freien Anschluß am ersten Koppelkondensator C1 und über diesen an der Basis des ersten Oszillatortransistors T1. Andererseits liegt der zweite Kondensator C* des kapazitiven Spannungsteilers mit seinem freien Anschluß an der das Bezugspotential führenden Versorgungsklemme, an die auch der negative Pol der dritten Gleichspannungsquelle U* angeschlossen ist. Der positive Pol der dritten Gleichspannungsquelle U* ist über den Widerstand R* gemäß der Definition der Erfindung einerseits mit dem Teilerpunkt, also einem Schaltungspunkt zwischen den beiden Kondensatoren C' und C* des kapazitiven Spannungsteilers und andererseits mit dem vom Transistor T2 abgewandten Anschluß des zweiten Koppelkondensators C2 verbunden. Schließlich liegt im Falle der Verwendung eines Parallel-Resonanz-Schwingkreises als frequenzsteuerndes Organ, wie bereits bemerkt, die Schwingkreisinduktivität L an den Endanschlüssen des kapazitiven Spannungsteilers C', C*.

Bei den bisher üblichen und unter Verwendung eines Differenzverstärkers T1, T2 aufgebauten Oszillatorschaltungen handelt es sich um sog. Zweipunktoszillatoren, bei denen die Basis des einen Transistors T1 mit dem Kollektor des zweiten Transistors T2 des Differenzverstärkers galvanisch oder kapazitiv verbunden ist. Der Mittenpunkt dieser Verbindung liegt dabei am Hochpunkt eines Parallel-Schwingkreises oder am Zwischenpunkt eines Serien-Resonanz-Schwingkreises. Die negative Steilheit des Admittanzverlaufs dieser Ankoppelpunkte sorgt dafür, daß die Schwingung am Ausgang des Oszillators erhalten bleibt. Jedoch führen die Blindanteile dieser Steilheit sowohl zu einer störenden Frequenzdrift als auch zu einer Verminderung des Durchstimmbereiches. Die endliche Verstärkung von der Basis des zweiten Transistors T2 des Differenzverstärkers zum Ausgang des Verstärkers am Kollektor des Transistors T2 reicht jedoch nicht immer aus, um den Schwingzustand aufrecht zu erhalten.

Wenn man nun entsprechend der Lehre der Erfindung einen den Eingang eines solchen Oszillators steuernden Schwingkreis oder Schwingquarz-Steuerkreis mit einer Serienkapazität C', C* anstelle eines einfachen Kondensators C ausstattet und den Hochpunkt oder den Mittenpunkt eines solchen Schwingkreises bzw. Quarzsteuerkreises entsprechend den von der Erfindung gegebenen Vorschlägen an die Oszillatortransistoren T1 und T2 ankoppelt, so wird der parasitäre kpazitive und reale Anteil der aktiven Schaltung am Gesamtschwingkreis oder Quarzsteuerkreis wesentlich reduziert. Damit wird der Frequenzvariationsbereich vergrößert sowie die Schwingsicherheit erhöht und die Neigung zu einer Frequenzdrift drastisch reduziert.

Ist der Oszillator für die Erzeugung von Betriebsfrequenzen im Fernsehbereich bestimmt, so wird man zweckmäßig den am ersten Kopplungskondensator C1 liegenden Kondensator C' des kapazitiven Spannungsteilers C', C* in Form einer Kapazitätsdiode realisieren. Gegebenenfalls kann auch der andere Kondensator C* durch eine Kapatzitätsdiode gegeben sein, was sich z. B. für den Kabel-Fernsehbereich oder für den UKW-Bereich empfiehlt. Durch das von der dritten Gleichspannungsquelle U* gelieferte und an den Widerstand R* gelegte Potential läßt sich unter Vermittlung dieses Widerstands R* die Kapazität der beiden Kondensatoren C' und C* beeinflussen, insbesondere, wenn wenigstens einer dieser beiden Kondensatoren durch eine Halbleiter-Kapazitätsdiode, also eine Varaktordiode oder auch durch eine normale pn-Übergangsdiode, realisiert ist. Die Beeinflussung der Kapazitäten C' und C* wirkt sich auf den Einstellungsbereich für die Schwingfrequenz vorteilhaft aus. Ist ein besonders großer Durchstimmbereich des Oszillators angestrebt, so kann man auch den ersten Koppelkondensator C1 in Serie mit einer weiteren Kapazitätsdiode schalten, die dann zweckmäßig zwischen dem Koppelkondensator C1 und dem ersten Kondensator C' des kapazitiven Spannungsteilers C', C* eingesetzt wird.

Es empfiehlt sich, die in Fig. 3 dargestellte Schaltung des Oszillators gemäß der Erfindung weitgehend monolithisch zusammenzufassen, so daß mit Ausnahme der Gleichspannungsquellen, der zu hohe Werte für die Integration aufweisenden Kapazitäten und Induktivitäten die aus Fig. 1 und auch aus Fig. 2 ersichtlichen Schaltungsteile in einem Chip vereinigt sind.

Geeignet für die Schaltung sind z. B. folgende Daten: Koppelkondensator C1 = 3,3 pF, Koppelkondensator C2 = 100 pF, Emittervorwiderstand R1 = 300 Ohm, Kondensator C3 = 20 pF, Widerstand R2 = R3 = 3 kΩ, Lastwiderstände R4 = R5 = 400 Ohm, U1: 7−8 V, U3: 2,8 V, U*: im Bereich von 0−28 V, Widerstand R* etwa 47 kΩ. Für die Kondensatoren C' und C* empfiehlt sich der Einsatz je einer der im Handel erhältlichen Kapazitätsdioden vom Typ BB609, insbesondere für den Einsatz der Schaltung beim Kabel-Fernsehen. Im übrigen bereitet es dem Fachmann keine besonderen Schwierigkeiten, die für einen bestimmten Einsatzbereich angebrachten Werte für die besagten Kapazitäten C' und C* zu ermitteln.

Wie bereits angedeutet wurde, kann man den zum Kollektor des zweiten Transistors des Differenzverstärkers, also des Transistors T2, führenden Koppelkondensator C2 durch einen Schwingquarz ersetzen, so daß auf diese Weise die Schaltung für einen quarzgesteuerten Oszillator gemäß der Erfindung etwas vereinfacht werden kann. Damit entfällt auch die in dem anderen oben beschriebenen Falle der Schaltung bei Verwendung einer Schwingquarzsteuerung vorhandene unmittelbare Verbindung zwischen den beiden Koppelkondensatoren C1 und C2. Dies führt zu einem sog. Obertonoszillator.

Die Vorteile und Möglichkeiten eines Oszillators gemäß der Erfindung kommen vor allem zum Tragen, wenn der Oszillator gemäß Fig. 4 durch eine nachgeschaltete Mischstufe zu einer Eingangsstufe für einen Überlagerungsempfänger ergänzt wird.

Die aus Fig. 4 ersichtliche Mischstufe besteht aus zwei Transistorpaaren T3 und T4 bzw. T5 und T6, wobei die einzelnen Transistoren vom selben Typ wie die Transistoren T1 und T2 des Oszillators sind. Die symmetrische Mischstufe kommt dadurch zustande, weil die npn-Transistoren T3 und T4 einerseits und die npn-Transistoren T5 und T6 andererseits über ihre Emitter paarweise miteinander verbunden sind und der Kollektor je eines Transistors der beiden Paare an die eine Ausgangsklemme A1 und der Kollektor je eines der beiden anderen Transistoren der beiden Paare an die andere Ausgangsklemme A2 gelegt ist. Im gezeichneten Beispielsfall liegt der Kollektor des Transistors T3 und der Kollektor des Transistors T5 an der Klemme A1, der Kollektor des Transistors T4 und der Kollektor des Transistors T6 an der Klemme A2 des Ausgangs der Mischstufe.

Andererseits sind die Transistoren T3 und T6 als auch die Transistoren T5 und T4 zu je einem Transistorpaar über ihre Basisanschlüsse zusammengefaßt, indem die beiden Transistoren T3 und T6 gemeinsam vom Kollektor des ersten Oszillator-Transistors T1 sowie die beiden Transistoren T4 und T5 gemeinsam vom Kollektor des zweiten Oszillatortransistors T2 über ihre Basisanschlüsse gesteuert werden.

Ferner liegen die Emitter der Transistoren T3 und T4 am Kollektor eines weiteren npn-Transistors T7 sowie die Emitter der Transistoren T5 und T6 am Kollektor eines sechsten npn-Transistors der Mischstufe, der mit T8 bezeichnet ist. Die Emitter der beiden zuletzt genannten npn-Transistoren T7 und T8 liegen über einen gemeinsamen Emitter-Vorwiderstand an dem Bezugspotential, also an der oben definierten Versorgungsklemme für das Bezugspotential. Der Emittervorwiderstand von T7 und T8 ist der Widerstand R4.

Eine vierte Gleichspannungsquelle U2 liegt mit ihrem nega-Pol an der genannten Versorgungsklemme für das Bezugspotential und mit ihrem positiven Pol über je einen Widerstand R5 bzw. R6 an der Basis des Transistors T7 und des Transistors T8. Außerdem bilden die Basisanschlüsse der beiden Transistoren T7 und T8 je einen durch ein z. B. über einen Vorverstärker (nicht dargestellt) geliefertes externes zu verarbeitendes Signal gemeinsam zu beaufschlagenden Anschluß E1, E2, also m. a. W. den Signaleingang der Mischstufe.

Jede der beiden Ausgangsklemmen A1*, A2* des Oszillators, d. h. also die Kollektoren der Oszillatortransistoren T1 und T2, sind über je einen Widerstand R9 bzw. R10 an je einen Eingang eines Regelverstärkers V gelegt. Außerdem sind die beiden Widerstände R9 und R10 an den dem Transistor T1 bzw. T2 abgewandten Anschluß über einen Kondensator C4 miteinander verbunden.

Damit bildet der Widerstand R9 und der Widerstand R10 mit dem Kondensator C4 einen Tiefpaß, durch den der Regelverstärker V gesteuert wird. Der Signalausgang des Regelverstärkers V liegt unmittelbar an der Basis des zweiten Oszillatortransistors T2. Der Tiefpaß R9, R10, C4 wird so dimensioniert, daß das Auftreten der Oszillatorschwingung am Eingang des Regelverstärkers V völlig unterdrückt wird. Dies führt dazu, daß die über den Regelverstärker V führende Gegenkopplung rein gleichstrommäßig wird. Die Folge davon ist, daß die im Prinzip unvermeidbare Unsymmetrie der Potentialänderungen an den beiden Ausgangsklemmen A1*, A2* des Oszillators vermindert wird. Dies wirkt sich im Sinne einer Unterdrückung des Oszillatorrauschens sowie einer Kompensation weiterer, vom Oszillator herrührender Störungen auf das vom Ausgang A1, A2 der Mischstufe gelieferte ZF-Signal aus.

Verständlich wird nun, daß die durch die Weiterbildung der Erfindung erreichte Verbesserung hinsichtlich des Betriebs des Oszillators sich auch im günstigen Sinne auf das am Ausgang der Mischstufe anfallende Signal auswirken muß.

Will man die in Fig. 2 dargestellte Schaltung im Sinne der Erfindung weiter verbessern, so wird man den dort im Schwingkreis 25 vorgesehenen Kondensator C als Spannungsteiler aus zwei hintereinandergeschalteten Kondensatoren C', C* realisieren und diese — zusammen mit einer weiteren Gleichspannungsquelle entsprechend der Gleichspannungsquelle U* und einem Widerstand entsprechend dem Widerstand R* — im Sinne der Fig. 1 und 2 der vorliegenden Anmeldung an den dem ersten Koppelkondensator C1 entsprechenden Kondensator 28 sowie an den dem zweiten Koppelkondensator C2 entsprechenden Kondensator 29 anschalten.

Abschließend ist zu der vorliegenden Transistor-Oszillatorschaltung gemäß der Erfindung noch zu sagen, daß anstelle von npn-Transistoren im Prinzip auch pnp-Transistoren verwendet werden können, da auch dann die von der Erfindung angestrebte Wirkung erreicht wird. Auch eine Realisierung in MOS-Technik ist möglich, zumal man auch dann geeignete Möglichkeiten zur Realisierung von Widerständen und Kondensatoren zur Verfügung hat und Differenzverstärker mit source-gekoppelten MOS-Transistoren, insbesondere vom Anreicherungstyp, ebenfalls zum Stande der Technik gehören.

**Patentansprüche**

1. Integrierbare Oszillatorschaltung mit einer durch ein externes Signal beaufschlagten Mischstufe, bei der der Oszillator von einem aus zwei emittergekoppelten Transistoren (T1, T2) bestehenden Differenzverstärker gebildet ist, dessen beide Transistoren (T1, T2) an ihren Emittern durch das von einer Gleichspannungsquelle (U1) gelieferte Bezugspotential und an ihren Kollektoren unter Vermittlung je eines Widerstands (R7, R8) durch das von dieser Gleichspannungsquelle (U1) gelieferte Betriebspotential beaufschlagt sind, bei der der Basisanschluß des ersten Transistors (T1) des Differenzverstärkers durch einen Schwingkreis oder einen Schwingquarz gesteuert und der Basisanschluß des zweiten Transistors (T2) des Differenzverstärkers über einen Kondensator (C3) an das Bezugspotential angeschlossen ist, bei der außerdem der Kollektor des zweiten Transistors (T2) einen die im Oszillator erzeugte elektrische Schwingung abgebenden Signalausgangsanschluß bildet und bei der schließlich eine rückkoppelnde Verbindung zwischen dem Kollektor des zweiten Transistors (T2) zur Basis des ersten Transistors (T1) vorgesehen ist, dadurch gekennzeichnet, daß die Kollektoren der beiden den Differenzverstärker bildenden Transistoren (T1, T2) sowohl an je einen Eingangsanschluß der symmetrisch ausgebildeten Mischstufe (T3—T6) als auch über je einen Tiefpaß (R9, C4; R10) an je einen Eingang eines Regelverstärkers (V) gelegt sind und der Ausgang dieses Regelverstärkers (V) auf den Oszillator im Sinne einer gleichstrommäßigen Gegenkopplung rückgekoppelt ist, derart, daß die Kollektorpotentiale der beiden Transistoren (T1, T2) des Oszillators und damit auch die Potentiale an den beiden Eingängen der Mischstufe möglichst symmetrisch liegen.

2. Anordnung nach Anspruch 1, dadurch gekennzeichnet, daß die Basis des ersten Transistors (T1; 41) sowie die Basis des zweiten Transistors (T2; 33) über je einen Widerstand (R2, R3; 69, 68) an den einen Pol einer weiteren Gleichspannungsquelle (U3) gelegt sind, deren anderer Pol mit dem Bezugspotential verbunden ist, daß außerdem die Rückkopplung zwischen dem Kollektor des zweiten Transistors (T2; 33) und der Basis des ersten Transistors durch die Reihenschaltung zweier Kondensatoren (C1, C2; 28, 29) gegeben und dabei der eine Kondensator (C2; 28) unmittelbar an den Kollektor des zweiten Transistors (T2; 33) und der andere Kondensator (C1; 29) unmittelbar an die Basis des ersten Transistors (T1; 41) gelegt sowie die Steuerung der Basis des ersten Transistors (T1; 41) durch den Schwingkreis (C, L bzw. Ls,C) bzw. den Schwingquarz ausschließlich über den an ihm liegenden der beiden Kondensatoren (C1, C2; 29, 28) gegeben ist, daß weiterhin der Kollektor des ersten und des zweiten Transistors (T1, T2; 41, 33) über je einen als Tiefpaß wirkenden Schaltungsteil (R9, C4; R10, C4 bzw. 26, 20; 27, 21) an je einen Eingang des mit seinem Ausgang an der Basis des zweiten Transistors (T2; 33) liegenden Regelverstärkers (V; 11—18, 30, 31, 68) gelegt ist.

3. Anordnung nach Anspruch 1 oder 2, dadurch gekennzeichnet, daß für den Aufbau der Mischstufe einander gleiche Transistoren verwendet sind, daß dabei die beiden durch je einen der beiden Transistoren (T1, T2) des Oszillators beaufschlagten Eingänge der Mischstufe (E1, E2; 113) an die Basis je eines Transistors (T7, T8; 106, 105) gelegt und außerdem über einen Widerstand (R5, R6; 122 bzw. 123) mit dem einen Pol einer Gleichspannungsquelle (U2) verbunden sind, deren anderer Pol am Bezugspotential liegt, daß außerdem die Emitter der beiden Transistoren über einen gemeinsamen Widerstand (R4; 104) mit dem Bezugspotential verbunden sind, während ihre Kollektoren an den Emittern je eines weiteren Transistorpaares (T3, T4, T5, T6; 107, 108, 109, 110) liegen, daß ferner jeder Transistor des einen dieser Transistorpaare (T3, T4; 107, 108) über seine Basis mit je einem der Transistoren (T5, T6; 109, 110) des anderen Transistorpaares über dessen Basis verbunden ist, während er über seinen Kollektor mit dem Kollektor des jeweils anderen Transistors des anderen Transistorpaares zusammengefaßt ist und auf diese Weise je einen Signalausgang (A1, A2; 114) der Mischstufe bildet, während die Basis der beiden Transistoren der je einen Ausgang bildenden Transistorpaare an den Kollektor je eines der beiden den Oszillator bildenden Transistoren (T1, T2; 41, 33) und damit an den Oszillatoreingang der Mischstufe angeschaltet ist.

4. Anordnung nach Anspruch 3, dadurch gekennzeichnet, daß die je einen Signalausgang der Mischstufe steuernden Kollektoren der vom Oszillator her gesteuerten Transistorpaare (107, 108, 109, 110) über die Emitter-Kollektorstrecke je eines weiteren Transistors (111, 112) an die zugehörige Klemme des Signalausgangs (114) gelegt und die Basisanschlüsse dieser Transistoren (111, 112) über einen gemeinsamen Widerstand (42) an den dem Bezugspotential abgewandten Pol der das Bezugspotential und das Betriebspotential für den den Oszillator bildenden Differenzverstärker (41, 33) liefernden Spannungsquelle (U1) gelegt sind.

5. Anordnung nach Anspruch 3 oder 4, dadurch gekennzeichnet, daß der dem Bezugspotential abgewandte Pol der das Bezugspotential und das Betriebspotential für den den Oszillator bildenden Differenzverstärker (41, 33) liefernden Spannungsquelle (U1) mit dem Kollektor zweier weiterer Transistoren (120, 121) verbunden ist, deren Basisanschlüsse durch den Kollektor je eines der beiden den Oszillator bildenden Transistoren beaufschlagt und deren in Emitterfolgerschaltung betriebene Emitter zur Steuerung je eines der beiden vom Oszillator her zu beaufschlagenden Eingänge (107—110) der Mischstufe vorgesehen sind.

6. Anordnung nach einem der Ansprüche 1 bis 5, dadurch gekennzeichnet, daß in dem frequenzbestimmenden Steuerorgan des Oszillators ein in diesem vorgesehener Kondensator (C') mit seinem einen Anschluß an dem zum ersten Transistor (T1) des Differenzverstärkers (T1, T2) führenden ersten Koppelkondensator (C1) und mit seinem zweiten Anschluß an dem zum Kollektor des zweiten Transistors (T2) des Differenzverstärkers (T1, T2) führenden zweiten Koppelkondensator (C2) unmittelbar angeschlossen ist, daß dabei ein weiterer Kondensator (C*) im frequenzbestimmenden Steuerorgan vorgesehen ist, derart, daß dieser weitere Kondensator (C*) mit seinem einen Anschluß mit dem von dem zweiten Transistor (T2) des Differenzverstärkers abgewandten Anschluß des zweiten Koppelkondensators (C2) unmittelbar als auch über einen Widerstand (R*) mit dem einen Pol einer weiteren Gleichspannungsquelle (U*) verbunden ist, während der andere Anschluß dieses weiteren Kondensators (C*) sowie der andere Pol der genannten Gleichspannungsquelle (U*) unmittelbar an der das Bezugspotential führenden Versorgungsklemme des Oszillators liegen.

7. Anordnung nach Anspruch 6, dadurch gekennzeichnet, daß wenigstens einer der beiden in dem frequenzbestimmenden Steuerorgan vorgesehenen Kondensatoren (C', C*) durch eine Halbleiterkapazitätsdiode gegeben ist.

8. Anordnung nach Anspruch 6 oder 7, dadurch gekennzeichnet, daß der die Verbindung zwischen dem frequenzbestimmenden Steuerorgan und dem ersten Transistor des Differenzverstärkers bildende Kondensator (C1) durch die Reihenschaltung eines Festkondensators mit einem abstimmbaren Kondensator gegeben ist, wobei der Festkondensator unmittelbar an der Basis des ersten Transistors (T1) des Differenzverstärkers und der abstimmbare Kondensator unmittelbar am ersten Kondensator (C') des frequenzbestimmenden Steuerorgans liegt.

9. Anordnung nach einem der Ansprüche 6 bis 8, dadurch gekennzeichnet, daß die Reihenschaltung der beiden Kondensatoren (C', C*) im frequenzbestimmenden Steuerorgan durch eine Induktivität (L) überbrückt ist und das Steuerorgan als Parallel-Resonanz-Schwingkreis ausgebildet ist.

10. Anordnung nach einem der Ansprüche 6 bis 8, dadurch gekennzeichnet, daß die Reihenschaltung der beiden Kondensatoren (C', C*) im frequenzbestimmenden Steuerorgan des Oszillators (T1, T2) in Serie mit einer Schwingkreisinduktivität oder einem Schwingquarz sowie dem zweiten und zum Kollektor des zweiten Transistors (T2) im Oszillator (T1, T2) führenden Koppelkondensator (C2) derart geschaltet ist, daß die Schwingkreisinduktivität bzw. der Schwingquarzkondensator zwischen dem zweiten Koppelkondensator (C2) und dem ersten Kondensator (C') liegt.

11. Anordnung nach einem der Ansprüche 6 bis 10, dadurch gekennzeichnet, daß der zum Kollektor des zweiten Transistors (T2) des Oszillators führende Koppelkondensator (C2) durch einen Schwingquarzkondensator gegeben ist.

## Claims

1. An integrable oscillator circuit, with a mixer stage to which is supplied an external signal, wherein the oscillator is formed by a differential amplifier which consists of two emitter-coupled transistors (T1, T2) and the two transistors (T1, T2) have their emitters fed from a reference potential terminal of a d.c. voltage source (U1) their respective collectors connected via respective resistors (R7, R8), to the operating potential terminal of this d.c. voltage source, wherein the base terminal of the first transistor (T1) of the differential amplifier is controlled by an oscillatory circuit or an oscillatory quartz crystal and the base terminal of the second transistor (T2) of the differential amplifier is connected via a capacitor (C3) to the reference potential, wherein moreover the collector of the second transistor (T2) forms a signal output terminal which emits the electrical oscillation generated in the oscillator and wherein finally a feedback connection is provided between the collector of the second transistor (T2) and the base of the first transistor (T1), characterized in that the collectors of the two transistors (T1, T2) which form the differential amplifier are each connected both to a respective input terminal of a symmetrically designed mixer stage (T3—T6) and also to a respective input of a regulating amplifier (V), in each case via a respective low-pass filter (R9, C4; R10), and the output of this regulating amplifier (V) provides d.c. negative feedback to the oscillator in such manner that the collector potentials of the two transistors (T1, T2) of the oscillator, and thus also the potential applied to the two inputs of the mixer stage are as symmetrical as possible.

2. An arrangement as claimed in claim 1, characterized in that the base of the first transistor (T1; 41) and the base of the second transistor (T2; 33) are each connected via a respective resistor (R2, R3; 69, 68) to the first pole of a further d.c. voltage source (U3) whose other pole is connected to the reference potential, that moreover the feedback between the collector of the second transistor (T2; 33) and the base of the first transistor is formed by the series arrangement of two capacitors (C1, C2; 28, 29) where the first capacitor (C2; 28) is directly connected to the collector of the second transistor (T2; 33) and the other capacitor (C1; 29) is directly connected to the base of the first transistor (T1; 41), and the control of the base of the first transistor (T1; 41) by the oscillatory circuit (C, L and Ls, C) or the oscillatory quartz crystal takes place exclusively via that member of the two capacitors (C1, C2; 29, 28) which is connected thereto, that moreover the collectors of the first and second transistors (T1, T2; 41, 33) are each connected via a respective low-pass filter circuit (R9, C4; R10, C4 and 26, 20; 27, 21), to a respective input of the regulating amplifier (V; 11—18, 30, 31, 68) whose output is connected to the base of the second transistor (T2 ; 33).

3. An arrangement as claimed in claim 1 or 2, characterized in that mutually identical transistors are used to construct the mixer stage, that the two inputs of the mixer stage (E1, E2; 113) each of which are connected to one of the two transistors (T1, T2) of the oscillator, are each connected to the base of one transistor (T7, T8; 106, 105) and moreover are connected via a resistor (R5, R6; 122 and 123) to the first pole of a d.c. voltage source (U2) whose other pole is connected to the reference potential, that moreover the emitters of the two transistors are connected via a common resistor (R4; 104) to the reference potential, whereas their collectors are each connected to the emitters of a further pair of transistors (T3, T4, T5, T6; 107, 108, 109, 110), that moreover each transistor of the first of these pairs of transistors (T3, T4; 107, 108) is connected via its base to one of the transistors (T5, T6; 109, 110) of the other pair of transistors via its base, whereas it is combined via its collector with the collector of the other transistor of the other pair of transistors and in this way in each case forms a signal output (A1, A2; 114) of the mixer stage, whereas the base of the two transistors of the pairs of transistors which each form an output is connected to the collector of one of the two transistors (T1, T2; 41, 33) which form the oscillator and thus is connected to the oscillator input of the mixer stage.

4. An arrangement as claimed in claim 3, characterized in that the collectors — which each control one signal output of the mixer stage — of the transistor pairs (107, 108, 109, 110) which are controlled by the oscillator are connected via the emitter-collector path of in each case one further transistor (111, 112) to the associated terminal of the signal output (114), and the base terminals of these transistors (111, 112) are connected via a common resistor (42) to that pole which is remote from the reference potential of the voltage source (U1) which supplies the reference potential and the operating potential for the differential amplifier (41, 33) which forms the oscillator.

5. An arrangement as claimed in claim 3 or 4, characterized in that that pole remote from the reference potential of the voltage source (U1) which supplies the reference potential and the operating potential for the differential amplifier (41, 33) which forms the oscillator is connected to the collectors of two further transistors (120, 121) whose base electrodes are each connected to the collector of a respective one of the two transistors which form the oscillator and whose emitters, which are operated in an emitter follower circuit, each serve to control one of the two inputs (107—110) of the mixer stage which are to be supplied from the oscillator.

6. An arrangement as claimed in one of claims 1 to 5, characterized in that in the frequency-determining control member of the oscillator, a capacitor (C') provided therein is directly connected by its first terminal to the first coupling capacitor (C1) which leads to the first transistor (T1) of the differential amplifier (T1, T2) and is directly connected by its second terminal to the second coupling capacitor (C2) which leads to the collector of the second transistor (T2) of the differential amplifier (T1, T2), that a further capacitor (C*) is provided in the frequency-determining control member in such manner that this further capacitor (C*) is directly connected by its first terminal to the terminal remote from the second transistor (T2) of the differential amplifier — of the second coupling capacitor (C2) and is also connected via a resistor (R*) to the first pole of a further d.c. voltage source (U*), whereas the other terminal of this further capacitor (C*) and the other pole of the aforementioned d.c. voltage source (U*) are directly connected to that supply terminal of the oscillator which conducts the reference potential.

7. An arrangement as claimed in claim 6, characterized in that at least one of the two capacitors (C', C*) provided in the frequency-determining control member consists of a semiconductor capacitance diode.

8. An arrangement as claimed in claim 6 or 7, characterized in that the capacitor (C1) which forms the connection between the frequency-determining control member and the first transistor of the differential amplifier consists of the series arrangement of a fixed capacitor and a tunable capacitor, where the fixed capacitor is directly connected to the base of the first transistor (T1) of the differential amplifier whereas the tunable capacitor is directly connected to the first capacitor (C') of the frequency-determining control member.

9. An arrangement as claimed in one of claims 6 to 8, characterized in that the series arrangement of the two capacitors (C', C*) in the frequency-determining control member is bridged by an inductance (L) and the control member represents a parallel-resonant oscillatory circuit.

10. An arrangement as claimed in one of claims 6 to 8, characterized in that the series arrangement of the two capacitors (C', C*) in the frequency-determining control member of the oscillator (T1, T2) is connected in series with an oscillatory circuit inductance or an oscillatory quartz crystal and the second coupling capacitor (C2) which leads to the collector of the second transistor (T2) in the oscillator (T1, T2) in such manner that the oscillatory circuit inductance or oscillatory quartz crystal capacitor is located between the second coupling capacitor (C2) and the first capacitor (C').

11. An arrangement as claimed in one of claims 6 to 10, characterized in that the coupling capacitor (C2) which leads to the collector of the second transistor (T2) of the oscillator consists of an oscillatory quartz crystal capacitor.

**Revendications**

1. Circuit oscillateur intégrable comportant un étage mélangeur chargé par un signal extérieur, et dans lequel l'oscillateur est formé par un amplificateur différentiel constitué par deux transistors (T1, T2) à émetteurs couplés, qui sont chargés, au niveau de leurs émetteurs, par le potentiel de référence délivré par une source de tension continue (U1) et, au niveau de leurs collecteurs, par le potentiel de service délivré par cette source de tension continue (U1), par l'intermédiaire de résistances respectives (R7, R8) et dans lequel la borne de base du premier transistor (T1) de l'amplificateur différentiel est commandé par un circuit oscillant ou par un quartz oscillateur et la borne de base du second transistor (T2) de l'amplificateur différentiel est raccordé par l'intermédiaire d'un condensateur (C3) au potentiel de référence, et dans lequel en outre le collecteur du second transistor (T2) forme une borne de sortie des signaux délivrant l'oscillation électrique produite dans l'oscillateur, et dans lequel enfin il est prévu une liaison de couplage par réaction entre le collecteur du second transistor (T2) et la base du premier transistor (T1), caractérisé par le fait que les collecteurs des deux transistors (T1, T2) constituant l'amplificateur différentiel sont raccordés tant à une borne respective d'entrée de l'étage mélangeur réalisé symétrique (T3—T6) que, par l'intermédiaire d'un filtre passe-bas respectif (R9, C4; R10), à une entrée respective d'un amplificateur de réglage (V), et que la sortie de cet amplificateur de réglage (V) est couplée par réaction à l'oscillateur dans le sens d'une contre-réaction en courant continu de telle sorte que les potentiels des collecteurs des deux transistors (T1, T2) de l'oscillateur et par conséquent également les potentiels présents sur les deux entrées de l'étage mélangeur sont aussi symétriques que possible.

2. Dispositif suivant la revendication 1, caractérisé par le fait que la base du premier transistor (T1; 41) ainsi que la base du second transistor (T2; 33) sont raccordées par l'intermédiaire de la résistance respective (R2, R3; 69, 68) à un pôle d'une source source de tension continue (U3), dont l'autre pôle est placé au potentiel de référence, qu'en outre le couplage de réaction entre le collecteur du second transistor (T2; 33) et la base du premier transistor est réalisé par le circuit série de deux condensateurs (C1, C2; 28, 29) et qu'un condensateur (C2; 28) est raccordé directement au collecteur du second transistor (T2; 33) et que l'autre condensateur (C1; 29) est raccordé directement à la base du second transistor (T1; 41), que la commande de la base du premier transistor (T1; 41) est réalisée par le circuit oscillant (C, L ou Ls, C) ou par le quartz oscillateur exclusivement par l'intermédiaire de celui des deux condensateurs (C1, C2; 29, 28), qui est raccordé au transistor, et qu'en outre les collecteurs des premier et second transistors (T1, T2; 41, 33) sont raccordés par l'intermédiaire d'éléments de circuit respectifs fonctionnant en tant que filtres passe-bas (R9; C4; R10, C4 ou 26, 20; 27, 21) à des entrées respectives de l'amplificateur de réglage (V; 11—18, 30, 31, 68) dont la sortie est reliée à la base du second transistor (T2; 33).

3. Dispositif suivant la revendication 1 ou 2, caractérisé par le fait que pour la réalisation de l'étage mélangeur on utilise des transistors identiques entre eux, que les deux entrées de l'étage mélangeur (E1, E2, 113), chargées respectivement par l'un des deux transistors (T1, T2) de l'oscillateur, sont raccordées aux bases des transistors respectifs (T7, T8, 106, 105) et en outre sont reliées par l'intermédiaire d'une résistance (R5, R6; 122 ou 123) à l'un des pôles d'une source de tension continue (U2), dont l'autre pôle est placé au potentiel de référence, qu'en outre les émetteurs des deux transistors sont reliés par l'intermédiaire d'une résistance commune (R4; 104) au potentiel de référence, tandis que leurs collecteurs sont raccordés aux émetteurs d'autres couples respectifs de transistors (T3, T4, T5, T6, 107, 108, 109, 110), qu'en outre chaque transistor de l'un de ces couples de transistors (T3, T4; 107, 108) est relié par sa base à respectivement l'un des transistors (T5, T6, 109, 110) de l'autre couple de transistors, tandis qu'il est relié par son collecteur au collecteur de l'autre transistor respectif de l'autre couple de transistors et forme de cette manière une voie respective de transmission de signaux (A1, A2; 114) de l'étage mélangeur, tandis que la base des deux transistors des couples de transistors formant des sorties respectives, est raccordée au collecteur respectivement de l'un des deux transistors (T1, T2, 41, 33) formant l'oscillateur, et par conséquent à l'entrée de l'oscillateur dans l'étage mélangeur.

4. Dispositif suivant la revendication 3, caractérisé par le fait que les collecteurs, commandant les sorties respectives de signaux de l'étage mélangeur, des couples de transistors (107, 108, 109, 110) commandés à partir de l'oscillateur sont raccordés par l'intermédiaire de la voie émetteur-collecteur d'un autre transistor respectif (111, 112) à la borne associée de la sortie des signaux (114), et que les raccords de base de ces transistors (111, 112) sont raccordés par l'intermédiaire des résistances communes (42) au pôle, qui est opposé au potentiel de référence, de la source de tension (U1) délivrant le potentiel de référence et le potentiel de service pour l'amplificateur différentiel (41, 33) formant l'oscillateur.

5. Dispositif suivant la revendication 3 ou 4, caractérisé par le fait que le pôle situé à l'opposé du potentiel de référence, de la source de tension (U1) délivrant le potentiel de référence et le potentiel de service pour l'amplificateur différentiel (41, 33) constituant l'oscillateur est relié au collecteur de deux autres transistors (120, 121) dont les bornes de base sont chargés respectivement par le collecteur de l'un des deux transistors formant l'oscillateur, et dont les émetteurs fonctionnant en émetteurs suiveurs sont prévus pour la commande respectivement de l'une des deux entrées (107—110) de l'étage mélangeur, devant être chargées à partir de l'oscillateur.

6. Dispositif suivant l'une des revendications 1 à 5, caractérisé par le fait que dans l'organe de commande de l'oscillateur, déterminant la fréquence, un condensateur (C') prévu dans ce dernier est raccordé directement par l'une de ces bornes au premier condensateur de couplage (C1) raccordé au premier transistor (T1) de l'amplificateur différentiel (T1, T2), et par sa seconde borne au second condensateur de couplage (C2) raccordé au collecteur du second transistor (T2) de l'amplificateur différentiel (T1, T2), qu'un autre condensateur (C*) est prévu dans l'organe de commande déterminant la fréquence de telle sorte que cet autre condensateur (C*) est relié par l'une de ses bornes directement à la borne du second condensateur de couplage (C2), située à l'opposé du second transistor (T2) de l'amplificateur différentiel, ainsi que par sa résistance (R*) à un pôle d'une autre source de tension continue (U*), tandis que l'autre borne de cet autre condensateur (C*) ainsi que l'autre pôle de ladite source de tension continue (U*) sont raccordés directement à la borne d'alimentation de l'oscillateur, reliée au potentiel de référence.

7. Dispositif suivant la revendication 6, caractérisé par le fait qu'au moins l'un des deux condensateurs (C', C*) prévu dans l'organe de commande déterminant la fréquence est constitué par une diode à capacité à semiconducteurs.

8. Dispositif suivant la revendication 6 ou 7, caractérisé par le fait que le condensateur (C1) formant la liaison entre l'organe de commande déterminant la fréquence et le premier transistor de l'amplificateur différentiel est formé par le circuit série d'un condensateur fixe et d'un condensateur réglable, le condensateur fixe étant relié directement à la base du premier transistor (T1) de l'amplificateur différentiel et le condensateur réglable étant relié directement au premier condensateur (C') de l'organe de commande déterminant la fréquence.

9. Dispositif suivant l'une des revendications 6 à 8, caractérisé par le fait que le circuit série des deux condensateurs (C', C*) dans l'organe de commande déterminant la fréquence est shunté par une inductance (L) et que l'organe de commande est réalisé sous la forme d'un circuit oscillant à résonance parallèle.

10. Dispositif suivant l'une des revendications 6 à 8, caractérisé par le fait que le circuit série des deux condensateurs (C', C*) dans l'organe de commande, déterminant la fréquence, de l'oscillateur (T1, T2) est branché en série avec une inductance du circuit oscillant ou avec un quartz oscillateur ainsi qu'avec le second condensateur de couplage (C2), relié au collecteur du second transistor (T2) dans l'oscillateur (T1, T2), de telle sorte que l'inductance du circuit oscillant ou le condensateur à cristal oscillateur est situé entre le second condensateur de couplage (C2) et le second condensateur (C').

11. Dispositif suivant l'une des revendications 6 à 10, caractérisé par le fait que le condensateur de couplage (C2) relié au collecteur du second transistor (T2) de l'oscillateur est constitué par un condensateur à cristal oscillateur.

# FIG 1

0 051 179

FIG 2

19

FIG 3

FIG 4